# EUROPÄISCHE PATENTSCHRIFT

(11) **EP 3 161 961 B1**
(45) Veröffentlichungstag und Bekanntmachung des Hinweises auf die Patenterteilung: **30.01.2019**
(21) Anmeldenummer: 15723919.5
(22) Anmeldetag: 19.05.2015
(51) Int. Cl.: H03K 17/94, F16H 59/10, H03K 17/968, F16H 59/04

(54) **VORRICHTUNG ZUM OPTOELEKTRONISCHEN ERFASSEN EINER WÄHLHEBELPOSITION, WÄHLHEBELVORRICHTUNG, VERFAHREN ZUM HERSTELLEN EINER VORRICHTUNG UND VERFAHREN ZUM OPTOELEKTRONISCHEN ERFASSEN EINER WÄHLHEBELPOSITION**
APPARATUS FOR OPTOELECTRONICALLY DETECTING A SELECTOR LEVER POSITION, SELECTOR LEVER APPARATUS, METHOD FOR PRODUCING AN APPARATUS AND METHOD FOR OPTOELECTRONICALLY DETECTING A SELECTOR LEVER POSITION
DISPOSITIF DE DÉTECTION OPTOÉLECTRONIQUE DE LA POSITION D'UN LEVIER DE SÉLECTION, DISPOSITIF À LEVIER DE SÉLECTION, PROCÉDÉ DE FABRICATION D'UN DISPOSITIF ET PROCÉDÉ DE DÉTECTION OPTOÉLECTRONIQUE DE LA POSITION D'UN LEVIER DE SÉLECTION

(30) Priorität: 24.06.2014 DE 102014212054
(43) Veröffentlichungstag der Anmeldung: 03.05.2017
(73) Patentinhaber: ZF Friedrichshafen AG, 88046 Friedrichshafen (DE)
(72) Erfinder: KIRILENKO, Alexander, 49356 Diepholz (DE); STRASSBURG, Karsten, 30167 Hannover (DE); RAKE, Ludger, 49439 Steinfeld (DE)
(86) Internationale Anmeldenummer: PCT/EP2015/060939
(87) Internationale Veröffentlichungsnummer: WO 2015/197263

(56) Entgegenhaltungen:
- WO-A1-03/081088
- DE-A1- 19 960 446
- DE-A1-102012 206 417
- JP-A- 2007 118 699

## Beschreibung

Die vorliegende Erfindung betrifft eine Vorrichtung zum optoelektronischen Erfassen unterschiedlicher Positionen eines Wählhebels zur Auswahl unterschiedlicher Gangstufen eines Gangwechselgetriebes, insbesondere eines Kraftfahrzeuggetriebes. Des Weiteren bezieht sich die Vorrichtung auf eine Wählhebelvorrichtung für ein Gangwechselgetriebe, insbesondere für ein Kraftfahrzeuggetriebe, auf ein Verfahren zum Herstellen einer Vorrichtung zum optoelektronischen Erfassen unterschiedlicher Positionen eines Wählhebels und ein Verfahren zum optoelektronischen Erfassen unterschiedlicher Positionen eines Wählhebels.

Eine Vorrichtung zum optoelektronischen Erfassen einer Wählhebelposition kann beispielsweise in einem Fahrzeug eingesetzt werden, um eine von einem Fahrer ausgewählte Gangstufe eines Kraftfahrzeuggetriebes zu erfassen und an ein Steuergerät zur Schaltung des Kraftfahrzeuggetriebes entsprechend der ausgewählten Gangstufe zu übertragen. Eine optoelektronische Erfassungsvorrichtung basiert dabei auf einem berührungslosen Erfassen der Wählhebelposition mittels Verwendung eines Licht emittierenden Leuchtmittels, einer das emittierte Licht oder das Leuchtmittel beeinflussenden Einrichtung sowie einem Lichtsensor zum Erfassen eines Anteils des emittierten Lichts, wobei der erfasste Lichtanteil einer Wählhebelposition zuordbar ist.

Die Druckschrift EP 0 844 418 offenbart eine optoelektronische Erfassungsvorrichtung, welche eine mit einem Wählhebel befestigbare Codierscheibe mit Lichtdurchlässen in vorbestimmter Anordnung aufweist, die in einer Lichtstrecke zwischen dem Leuchtmittel und dem Lichtsensor mit dem Wählhebel beweglich angeordnet ist. In jeder der zu erfassenden Wählhebelposition wird mittels der Codierscheibe ein vorbestimmtes Lichtmuster in Richtung des Lichtsensors übertragen, wobei jedes vorbestimmte Lichtmuster einer vorbestimmten erfassbaren Wählhebelposition zugeordnet ist. Ein ähnliches Erfassungsprinzip offenbaren beispielsweise die Dokumente DE 199 60 446, JP 2007-118699 und EP 2 687 760.

Vor diesem Hintergrund schafft die vorliegende Erfindung eine verbesserte Vorrichtung zum optoelektronischen Erfassen einer Wählhebelposition, eine Wählhebelvorrichtung, ein Verfahren zum Herstellen einer Vorrichtung zum optoelektronischen Erfassen einer Wählhebelposition und ein Verfahren zum optoelektronischen Erfassen einer Wählhebelposition. Insbesondere wird mit den vorgeschlagenen Vorrichtungen und Verfahren eine alternative optoelektronische Erfassungsvorrichtung bereitgestellt, welche weiterhin kompakter und kostengünstiger ausbildbar ist. Vorteilhafte Ausgestaltungen ergeben sich aus den Unteransprüchen und der nachfolgenden Beschreibung.

Die vorliegende Erfindung macht sich im Besonderen eine Lichteigenschaft des von einem Leuchtmittel emittierten Lichts zunutze. Unter einer Lichteigenschaft sind die ein Licht kennzeichnenden Faktoren wie beispielsweise die Lichtwellenlänge, die Lichtintensität bzw. Lichtstärke und eine Lichtabstrahlfrequenz bzw. Blinkfrequenz des Lichtes zu verstehen, wobei die vorliegenden Erfindung im Besonderen die die Lichtwellenlänge zur Erfassung einer Wählhebelposition hernimmt.

Die mit der vorliegenden Erfindung vorgeschlagene Vorrichtung ist mit einem Wählhebel koppelbar und umfasst wenigstens ein Leuchtmittel zum Emittieren von Licht und einen Lichtsensor zum Erfassen des emittierten Lichts. Bei dem Leuchtmittel kann es sich beispielsweise um eine Licht emittierende Diode (LED) oder eine konventionelle Glühbirne handeln. Bei dem Lichtsensor kann es sich beispielsweise um einen Photohalbleiter, weiter bevorzugt um eine Photodiode oder einen Phototransistor handeln. Die vorgeschlagene Vorrichtung zeichnet sich dadurch aus, dass der Lichtsensor vorgesehen ist, eine mittels eines in eine Lichtstrecke zwischen dem wenigstens einen Leuchtmittel und dem Lichtsensor anordenbaren Lichtfilters gefilterte Wellenlänge des emittierten Lichts zu erfassen und eine Information über die erfasste Wellenlänge an eine Auswerteeinrichtung zu übermitteln. Dabei sind vorbestimmte gefilterte Wellenlängen vorbestimmten Wählhebelpositionen, welche aus den unterschiedlichen Positionen des Wählhebels ausgewählt sind, zugeordnet. Bei dem Lichtsensor handelt es sich vorzugsweise um einen optischen Detektor beziehungsweise optoelektronischen Sensor, der Licht unter Benutzung eines fotoelektrischen Effekts in ein elektrisches Signal umwandelt und einen von der einfallenden Lichtstrahlung abhängigen elektrischen Widerstand ausgibt. Der Lichtsensor ist dabei auf das wenigstens eine Leuchtmittel beziehungsweise das von dem wenigstens einen Leuchtmittel emittierte Licht abgestimmt. Der Lichtsensor kann somit ein Lichtwellenlängensensor sein. Weiterhin bevorzugt ist das wenigstens eine Leuchtmittel ausgelegt, Licht im sichtbaren Bereich zu emittieren, während der Lichtsensor vorgesehen ist, das von dem wenigstens einem Leuchtmittel emittierte Licht im sichtbaren Bereich zu erfassen.

Damit kann wenigstens eine alternative Lösung für eine optoelektronische Erfassungsvorrichtung bereitgestellt werden. Ferner ermöglicht die vorgeschlagene Lösung einen hohen Freiheitsgrad hinsichtlich einer bedarfsgerechten Ausgestaltung einer optoelektronischen Erfassungsvorrichtung.

Nach einer bevorzugten Ausführungsform umfasst die Erfassungsvorrichtung einen Lichtschacht, welcher einen Lichtraum begrenzt, in welchem das wenigstens eine Leuchtmittel angeordnet ist. Der Lichtschacht kann beispielsweise das wenigstens eine Leuchtmittel umgebende Wandungen aufweisen. Weiter bevorzugt kann der Lichtschacht von einem das wenigstens eine Leuchtmittel tragende beziehungsweise haltende Trägerelement abragen. Weiterhin bevorzugt kann der Lichtschacht auf dem Trägerelement anliegen. Dadurch kann ein Lichtstreuverlust zwischen dem Lichtschacht und dem trägermaterial weitestgehend minimiert werden. Zusätzlich dazu kann der Lichtschacht vorzugsweise mit dem Trägerelement verbunden sein. Damit kann eine stabile Anordnung des Lichtschachts auf dem Trägermaterial ermöglicht werden. Die Verbindung zwischen dem Lichtschacht und dem Trägermaterial kann mittels üblicher Verbindungsarten wie Klebe-, Klemm-, Rast-, Schraubverbindungen oder ähnliches realisiert sein. Denkbar ist es nach einer bevorzugten Ausführungsform, dass der Lichtschacht und das Trägermaterial aus einem Stück ausgeformt sind.

Der von dem Lichtschacht begrenzende Raum formt den Lichtraum aus, welcher von dem wenigstens einen Leuchtmittel in einem aktiven Zustand beleuchtet ist. Mit anderen Worten ist das von dem wenigstens einen Leuchtmittel emittierte Licht in dem Lichtraum wenigstens in seitlicher Richtung ausgehend von dem wenigstens einem Leuchtmittel gefangen. Der Lichtschacht kann vorzugsweise auf den den Lichtraum begrenzenden Seiten reflektierende Oberflächen aufweisen, um einen Absorptionsverlust des emittierten Lichts in dem Lichtschacht zu reduzieren. Der Lichtschacht wirkt mit einem Lichteintritt zusammen, der angrenzend zu oder in dem Lichtraum zu dem wenigstens einen Leuchtmittel relativ beweglich an dem Wählhebel befestigbar ist, wobei der Lichtsensor mit dem Lichteintritt derart gekoppelt ist, dass der Lichtsensor wenigstens einen Anteil eines in den Lichteintritt einfallenden Lichtanteils des emittierten Lichts erfasst bzw. sensiert. Der Lichtschacht kann dazu vorzugsweise eine Öffnung umfassen, entlang welcher der Lichteintritt mittels Bewegung des Wählhebels bewegbar ist. Alternativ dazu kann der Lichtschacht eine Öffnung umfassen, in welche ein den Lichteintritt haltendes Halteelement eingreift, um den Lichteintritt innerhalb des Lichtraumes beweglich zu führen. Das Haltelement kann dabei weiterhin bevorzugt ein freies Ende des Wählhebels sein. Somit kann der Lichteintritt unmittelbar an dem Wählhebel befestigt sein. Die Öffnung ist vorzugsweise dem wenigstens einem Leuchtmittel gegenüberliegt ausgebildet. Beispielsweise kann die Öffnung in einem dem wenigstens einem Leuchtmittel gegenüberliegenden, wenigstens den Lichtraum abdeckenden Lichtschachtdeckel ausgeformt sein.

Weiterhin bevorzugt ist das wenigstens eine Leuchtmittel ausschließlich an einem einer einnehmbaren Endposition des Wählhebels zugeordneten Ort angeordnet. Dadurch kann sichergestellt werden, dass an dem der Endposition des Wählhebels zugeordneten Ort die Lichtintensität des von dem wenigstens einen Leuchtmittel emittierten Lichts den größten Wert aufweist. Mit anderen Worten ist ausgehend von der Endposition des Wählhebels und dem zugeordneten Ort in dem Lichtschacht an den anderen Orten, denen jeweils eine zu der Endposition unterschiedliche Position des Wählhebels zugeordnet ist, kein Leuchtmittel angeordnet oder vorgesehen. Mit zunehmender Entfernung einer möglichen Position des Wählhebels zu der Endposition des Wählhebels nimmt die Lichtintensität des von dem wenigstens einen Leuchtmittel emittierten Lichts somit ab. Mittels Zuordnung entsprechender Lichtintensitätsbereiche einer der einnehmbaren Positionen des Wählhebels kann dadurch in vorteilhafter Weise die mögliche Position des Wählhebels zuverlässig durch den Lichtsensor detektiert werden. Zur Steigerung der Lichtintensität kann an dem der Endposition zugeordnetem Ort vorzugsweise mehr als ein Leuchtmittel angeordnet sein. Dadurch kann in dem Lichtraum eine zuverlässigere Erfassung einer jeweiligen an einem Ort der möglichen Wählhebelposition vorherrschenden Lichtintensität erreicht werden. Die Endposition kann beispielsweise eine Gangstufe D für Vorwärtsfahrbetrieb oder R für Rückwärtsfahrbetrieb oder P für Parkstellung sein, wobei die letztgenannte Endposition für Wählhebelvorrichtungen in Frage kommt, bei welcher die Parkstellung mittels des Wählhebels wählbar ist. Sofern die Parkstellung beispielsweise mittels eines Tasters betätigbar ist, ist es bevorzugt, dass das wenigstens eine Leuchtmittel der Endposition D oder R zugeordnet ist.

Nach einer weiteren bevorzugten Ausführungsform ist der Lichtsensor an dem Wählhebel befestigbar, wobei der Lichteintritt von dem Lichtsensor umfasst ist. Damit kann die Erfassungsvorrichtung mit einer Wählhebelvorrichtung derart kombiniert werden, dass eine kompakte Ausgestaltung von Wählhebel- und Erfassungsvorrichtung möglich ist. Des Weiteren kann somit eine einfach aufgebaute Erfassungsvorrichtung zum Erfassen der Wählhebelposition bereitgestellt werden.

Gemäß einer alternativ bevorzugten Ausführungsform ist ein Lichtleiter an dem Wählhebel befestigbar, wobei der Lichtleiter einen Lichtaustritt umfasst, der gegenüber einer Sensorfläche des Lichtsensor angeordnet ist, wobei der Lichtaustritt mit dem Lichteintritt über ein Lichtleitstreckenelement miteinander verbunden ist, mittels welchem der in den Lichteintritt einfallende Lichtanteil des emittierten Lichts zu dem Lichtaustritt geleitet wird. Das Lichtleitstreckenelement kann ein Licht leitender Vollkörper oder ein Licht reflektierender Hohlkörper sein, in dem der in den Lichteintritt eintretende Lichtanteil des emittierten Lichts in Richtung des Lichtaustritts reflektiert beziehungsweise gespiegelt wird. Das Lichtleitstreckenelement ist weiter bevorzugt flexibel ausgebildet, um einer Bewegung des Wählhebels entsprechend folgen zu können. Das flexible Lichtleitstreckenelement kann beispielsweise aus einem Flüssigsilikon (LSR = liquid silicon rubber) ausgeformt sein. Alternativ dazu kann das Lichtleitstreckenelement im Bereich einer Lagerung des Wählhebels ein Lichtleitkopplungselement aufweisen, über welchen der in den Lichteintritt eintretende Lichtanteil des emittierten Lichts über einen mit dem Lichtaustritt verbundenen Lichtleitstreckenelementabschnitt geleitet wird. Weiterhin bevorzugt kann das Lichtleitstreckenelement innerhalb des Wählhebels in einem Bereich wenigstens von einem dem wenigstens einem Leuchtmittel gegenüberliegenden freien Ende des Wählhebels bis zu einem Wählhebelaustritt für das Lichtleitstreckenelement angeordnet sein. Der Wählhebelaustritt kann dabei im Bereich der Lagerung des Wählhebels liegen. Diese bevorzugte Ausführungsform ist im Besonderen in Verbindung mit dem Lichtleitkopplungselement bevorzugt. Dadurch können an dem Wählhebel außenseitig anzuordnende Lichtleitungen vermieden werden, welche anfälliger gegenüber äußeren Einflüssen als in dem Wählhebel verlaufende Lichtleitungen sind.

Nach einer weiteren bevorzugten Ausführungsform ist in dem Lichtschacht für jede von der im Wählhebel einnehmbaren Position zur Auswahl einer Gangstufe ein Leuchtmittel angeordnet, wobei jeweils benachbarte Leuchtmittel mittels eines dazwischen angeordneten Lichtabschirmelements zueinander abgeschirmt sind. Dabei sind jeweils benachbarte Leuchtmittel ausgebildet, Licht mit einer unterschiedlichen Lichtintensität zu emittieren. Weiter bevorzugt sind sämtliche Leuchtmittel ausgebildet, Licht mit einer zu den anderen Leuchtmitteln unterschiedlichen Lichtintensität zu emittieren. Dadurch kann auf eine einfache und zuverlässige Weise eine Zuordnung der möglichen einnehmbaren Wählhebelpositionen zu den jeweiligen Lichtintensitätsbereichen erfolgen. Unterschiedliche Lichtintensitäten der jeweiligen Leuchtmittel lassen sich beispielsweise durch Vorschaltung eines Vorwiderstandes vor dem jeweiligen Leuchtmittel erreichen. Damit könnten für die jeweiligen Leuchtmittel gleiche Leuchtmittelarten eingesetzt werden, wobei auf dem Träger dem jeweiligen Leuchtmittel ein entsprechender Vorwiderstand elektrisch vorgeschaltet ist. Dadurch kann eine Anordnung von Leuchtmitteln mit Lichtemissionen von unterschiedlicher Lichtintensität ermöglicht werden. Alternativ dazu können unterschiedliche Leuchtmitteltypen mit vornherein unterschiedlicher Lichtintensität ausgewählt und für die vorgeschlagene Vorrichtung vorgesehen sein.

Gemäß einer weiteren bevorzugten alternativen Ausführungsform weist der Lichtschacht einen zu dem Lichtsensor führenden Durchgang auf, wobei ein Lichtreflexionselement an dem Wählhebel befestigbar ist, welches den Lichteintritt und einen Lichtaustritt ausbildet, wobei ein in den Lichteintritt einfallender Lichtanteil des emittierten Lichts über den Lichtaustritt in Richtung des Durchganges reflektiert wird. Bei dem Lichtreflexionselement kann es sich beispielsweise um ein Lichtspiegelelement mit lichtspiegelnder Oberfläche handeln, welches mit dem Wählhebel drehbeweglich ist. Die spiegelnde Oberfläche formt dabei zum einen den Lichteintritt als auch den Lichtaustritt aus. Unter Anwendung des Lichtreflexionsgesetzes wird das auf die spiegelnde Oberfläche einfallende Licht in einem gleichen Winkel abgestrahlt bzw. reflektiert. Abhängig von dem Winkel wird der zu dem Lichtsensor führende Durchgang mit unterschiedlicher Lichtintensität beaufschlagt, so dass entsprechend einer Wählhebelstellung beziehungsweise Wählhebelposition unterschiedliche Lichtintensitäten von dem Lichtsensor detektiert werden. Somit lassen sich für jede Wählhebelposition Lichtintensitätsbereiche zuordnen, mittels welcher eine Position des Wählhebels durch den Lichtsensor erfassbar ist. Damit lässt sich eine kostengünstige und einfach aufgebaute Erfassungsvorrichtung zum Erfassen unterschiedlicher Positionen eines Wählhebels bereitstellen.

Gemäß einer weiteren bevorzugten alternativen Ausführungsform ist ein Lichtfilter an den Wählhebel in einer Lichtstrecke zwischen dem Leuchtmittel und dem Lichtsensor befestigbar, wobei der Lichtfilter eine Anzahl an zu erfassenden unterschiedlichen Wählhebelpositionen gleiche Anzahl an unterschiedlichen Farbfilterelementen zum vorbestimmten Filtern des in den Lichteintritt einfallenden Lichtanteils des emittierten Lichts aufweist, wobei jedes Farbfilterelement mit einer dem Leuchtmittel zugewandten Oberflächenseite den Lichteintritt ausformt. Das Leuchtmittel kann dabei eine weißleuchtende Licht emittierende Diode (LED) sein, welche mit den jeweiligen Farbfilterelementen derart zusammenwirkt, dass die jeweiligen Farbfilterelemente die dem jeweiligen Farbfilterelement zugeordnete Farbe aus dem weißen Licht der weißleuchtenden LED herausfiltern. Alternativ zu der weißleuchtenden LED können durchaus andere weißleuchtende Leuchtmitteltypen verwendet werden. Da somit auf mehrere farbleuchtende Leuchtmittel verzichtet werden kann, kann eine kostengünstige Erfassungsvorrichtung bereitgestellt werden. Die dem Lichtsensor vorgeschaltete Farbfilterelemente in den jeweiligen Positionen des Wählhebels ermöglichen dadurch eine gleichartige Sensierung als wenn farbleuchtende Leuchtmittel Anwendung gefunden hätten. Ferner kann mittels der Farbfilterelemente die Anzahl der notwendigen Leuchtmittel erheblich reduziert werden.

Nach einer weiteren bevorzugten Ausführungsform sind der Lichtsensor und das wenigstens eine Leuchtmittel auf einem gemeinsamen Trägerelement angeordnet. Das Trägerelement ist vorzugsweise eine übliche Leiterplatte, mittels welche elektronische Bauelemente mit elektrischer Energie versorgbar und elektrisch leitend anbindbar sind. Dadurch kann eine kompakte Ausgestaltung der Vorrichtung ermöglicht werden.

Gemäß einem weiteren Aspekt der vorliegenden Erfindung wird eine Wählhebelvorrichtung für ein Gangwechselgetriebe, insbesondere für ein Kraftfahrzeuggetriebe vorgeschlagen, wobei die Wählhebelvorrichtung einen zwischen unterschiedlichen Positionen bewegbaren Wählhebel zur Auswahl unterschiedlicher Gangstufen des Gangwechselgetriebes umfasst. Die vorgeschlagene Wählhebelvorrichtung zeichnet sich dadurch aus, dass der Wählhebel eine Kopplungsstelle zur Kopplung mit einer wie vorbeschriebenen Vorrichtung umfasst. Vorzugsweise ist die Kopplungsstelle vorgesehen, einen Lichtsensor, einen Lichtleiter oder einen Lichtfilter an dem Wählhebel anzuordnen und mit diesem zu verbinden oder zu befestigen. Dabei kann die Vorrichtung zum optoelektronischen Erfassen vorzugsweise in der Wählhebelvorrichtung integriert angeordnet sein. Dadurch kann eine kompakte Einheit aus Wählhebelvorrichtung und Erfassungsvorrichtung bereitgestellt werden. Alternativ dazu kann nach einer bevorzugten Ausführungsform die Erfassungsvorrichtung benachbart zu der Wählhebelvorrichtung anordenbar und weiter bevorzugt an der Wählhebelvorrichtung angekoppelt sein. Somit kann in alternativer Weise eine an bestehende Wählhebelvorrichtungen anordenbare Erfassungsvorrichtung bereitgestellt werden, wobei die Verbindung zwischen der Erfassungsvorrichtung und der Wählhebelvorrichtung mittels entsprechender üblicher Verbindungsmittel beziehungsweise Verbindungseinrichtung wie beispielsweise einer Klemm-, Rast- oder Schraubverbindungseinrichtung realisierbar ist. Damit kann die Erfassungsvorrichtung zudem modular an die Wählhebelvorrichtung anbindbar beziehungsweise mit dieser verbindbar sein. Weiter bevorzugt ist die Erfassungsvorrichtung lösbar an der Wählhebelvorrichtung ankoppelbar. Dadurch kann die Erfassungsvorrichtung im Defektfall auf einfache Weise modular ausgetauscht werden.

Nach einem weiteren Aspekt der vorliegenden Erfindung wird ein Verfahren zum Herstellen einer Vorrichtung zum optoelektronischen Erfassen unterschiedlicher Positionen eines Wählhebels zur Auswahl unterschiedlicher Gangstufen eines Gangwechselgetriebes vorgeschlagen. Das Verfahren umfasst einen Schritt des Bereitstellens wenigstens eines Leuchtmittels und eines Lichtsensors. Der Lichtsensor ist vorgesehen, eine mittels eines in eine Lichtstrecke zwischen dem wenigstens einen Leuchtmittel und dem Lichtsensor anordenbaren Lichtfilters gefilterte Wellenlänge des emittierten Lichts zu erfassen und eine Information über die erfasste Wellenlänge an eine Auswerteeinrichtung zu übermitteln. Vorbestimmte gefilterte Wellenlängen sind dabei vorbestimmten Wählhebelpositionen, welche aus den unterschiedlichen Positionen des Wählhebels ausgewählt sind, zugeordnet. Das Verfahren umfasst des Weiteren einen Schritt des Anordnens des wenigstens einen Leuchtmittels und des Lichtsensors derart, dass wenigstens ein Lichtanteil des von dem wenigstens einen Leuchtmittel emittierten Lichts mittels des Lichtsensors erfassbar ist. Mittels dieses vorgeschlagenen Verfahrens lässt sich in vorteilhafter Weise eine wie vorbeschriebene Vorrichtung bereitstellen.

Gemäß einem weiteren verfahrensmäßigen Aspekt der vorliegenden Erfindung wird ein Verfahren zum optoelektronischen Erfassen unterschiedlicher Positionen eines Wählhebels zur Auswahl unterschiedlicher Gangstufen eines Gangwechselgetriebes vorgeschlagen. Das Verfahren umfasst einen Schritt des Bewegens des Wählhebels in eine von einer Ausgangsposition unterschiedliche Position und einen Schritt des Erfassens eines Lichtanteils eines von wenigstens einem Leuchtmittel emittierten Lichts mittels eines Lichtsensors. Der Lichtsensor ist vorgesehen, eine mittels eines in eine Lichtstrecke zwischen dem wenigstens einen Leuchtmittel und dem Lichtsensor anordenbaren Lichtfilters gefilterte Wellenlänge des emittierten Lichts zu erfassen und eine Information über die erfasste Wellenlänge an eine Auswerteeinrichtung zu übermitteln. Dabei sind vorbestimmte gefilterte Wellenlängen vorbestimmten Wählhebelpositionen, welche aus den unterschiedlichen Positionen des Wählhebels ausgewählt sind, zugeordnet. Das vorgeschlagene Verfahren kann beispielsweise mittels einer wie vorbeschriebenen Vorrichtung durchgeführt werden. Mittels des Verfahrens kann eine einfache und schnelle Erfassung einer Wählhebelposition erreicht werden.

Vorzugsweise kann dem Schritt des Erfassens eines Lichtanteils ein Schritt des Aktivierens des Leuchtmittels vorangestellt sein. Der Aktivierschritt kann dabei beispielsweise mit dem Schritt des Bewegens des Wählhebels kombiniert oder diesem Schritt vorgelagert oder nachgelagert sein. Dadurch kann sichergestellt werden, dass das wenigstens eine Leuchtmittel nur dann mit ausreichender elektrischer Energie zum Emittieren von Licht beaufschlagt wird, wenn der Wählhebel bewegt wird. Somit kann ein Energieverbrauch reduziert werden.

Weitere Merkmale und Vorteile der Erfindung ergeben sich aus der nachfolgenden Beschreibung von bevorzugten Ausführungsbeispielen der Erfindung, anhand der Figuren und Zeichnungen, die erfindungswesentliche Einzelheiten zeigen, und aus den Patentansprüchen. Die einzelnen Merkmale können je einzeln für sich oder zu mehreren in beliebiger Kombination bei einer bevorzugten Ausführungsform verwirklicht sein.

Bevorzugte Ausführungsbeispiele werden nachfolgend anhand der beigefügten Zeichnungen näher erläutert. Es zeigen:
- Fig. 1: eine schematische Darstellung einer Vorrichtung zum optoelektronischen Erfassen unterschiedlicher Positionen eines Wählhebels nach einem bevorzugten Ausführungsbeispiel;
- Fig. 2: eine graphische Darstellung einer Lichtintensitätsverteilung einer in Fig. 1 gezeigten Vorrichtung;
- Fig. 3: eine schematische Darstellung einer Erfassungsvorrichtung nach einem weiteren bevorzugten Ausführungsbeispiel;
- Fig. 4: eine graphische Darstellung einer Lichtintensitätsverteilung einer in Fig. 3 gezeigten Vorrichtung;
- Fig. 5: eine schematische Darstellung einer Erfassungsvorrichtung nach einem weiteren bevorzugten Ausführungsbeispiel;
- Fig. 6: eine schematische Darstellung einer Erfassungsvorrichtung nach einem weiteren bevorzugten Ausführungsbeispiel;
- Fig. 7: eine schematische Darstellung einer Erfassungsvorrichtung nach einem weiteren bevorzugten Ausführungsbeispiel;
- Fig. 8: eine graphische Darstellung einer Lichtintensitätsverteilung einer in Fig. 7 gezeigten Vorrichtung;
- Fig. 9: eine schematische Darstellung einer Erfassungsvorrichtung nach einem weiteren bevorzugten Ausführungsbeispiel;
- Fig. 10: eine weitere schematische Darstellung der in Fig. 9 gezeigten Erfassungs-vorrichtung;
- Fig. 11: ein Ablaufdiagramm eines Verfahrens zum Herstellen einer Vorrichtung zum optoelektronischen Erfassen unterschiedlicher Positionen eines Wählhebels nach einem bevorzugten Ausführungsbeispiel; und
- Fig. 12: ein Ablaufdiagramm eines Verfahrens zum optoelektronischen Erfassen unterschiedlicher Positionen eines Wählhebels nach einem bevorzugten Ausführungsbeispiel.

In der nachfolgenden Beschreibung bevorzugter Ausführungsbeispiele werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

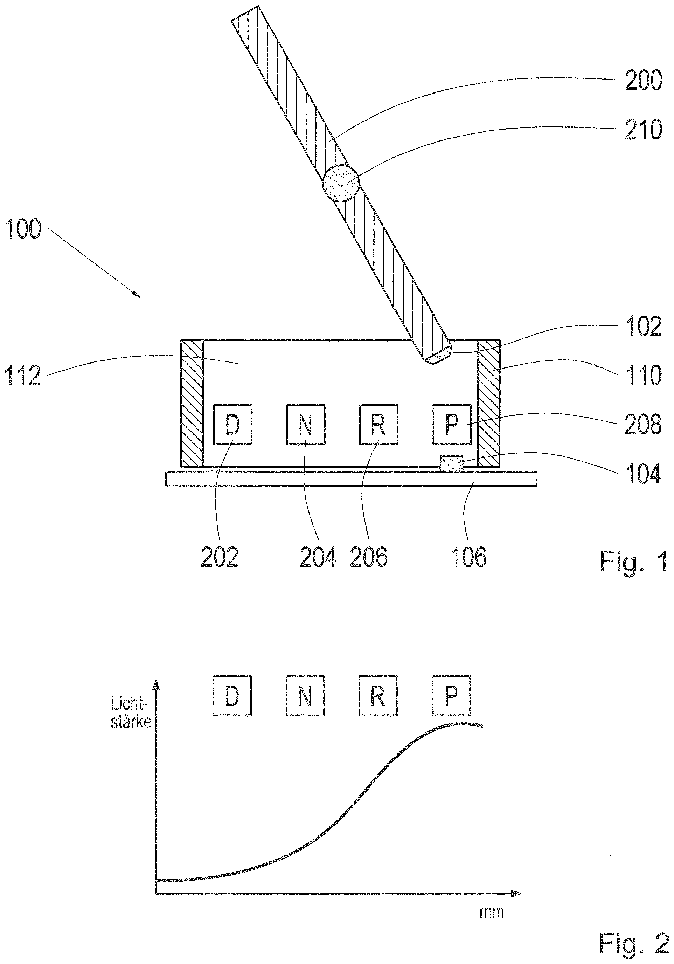

Fig. 1 zeigt eine schematische Darstellung einer Vorrichtung 100 zum optoelektronischen Erfassen unterschiedlicher Positionen eines Wählhebels 200 zur Auswahl unterschiedlicher Gangstufen 202, 204, 206, 208 eines Gangwechselgetriebes. Im Einzelnen ist die Gangstufe 202 einem Vorwärtsfahrbetrieb D für Drive, die Gangstufe 204 einer Neutralstellung N, die Gangstufe 206 einem Rückwärtsfahrbetrieb R und die Gangstufe 208 einer Parkstellung P zugeordnet. Der Wählhebel 200 ist drehbeweglich mittels einer kardanischen Lagerung 210 in einem nicht dargestellten Wählhebelgehäuse einer Wählhebelvorrichtung gelagert. Der Wählhebel 200 ist in Fig. 1 in einer von zwei Endpositionen der Wählhebeldrehbewegung gezeigt, wobei die Gangstufe 208 für die Parksperrenstellung P ausgewählt ist. Der Wählhebel 200 weist an einem seiner längsseitigen Enden einen Lichtsensor 102 auf, wobei der Lichtsensor 102 an dem freien Längsende des Wählhebels 200 angeordnet ist, welches dem freien längsseitigen Ende des Wählhebels 200 gegenüberliegt, über welchen ein Bediener des Wählhebels 200 eine Betätigungskraft zum Betätigen des Wählhebels 200 einbringen kann. Das den Lichtsensor 102 tragende freie längsseitige Ende des Wählhebels 200 ragt in einen Lichtraum 112 eines Lichtschachts 110 der Erfassungsvorrichtung 100 hinein. Der Lichtschacht 110 ist durch einen Hohlkörper ausgeformt, dessen Innenraum den Lichtraum 112 definiert. Der Lichtschacht 110 ist auf einer Seite eines Trägerelements 106 auf diesem angeordnet, dessen Seite gleichfalls ein Leuchtmittel 104 trägt. Das Leuchtmittel 104 ist innerhalb des Lichtraums 112 angeordnet. Das Leuchtmittel 104 ist bei diesem bevorzugten Ausführungsbeispiel eine weißleuchtende Licht emittierende Diode (LED). Bei dem Trägerelement 106 handelt es sich bei diesem bevorzugten Ausführungsbeispiel um eine Leiterplatte mit Leiterbahnen zum elektrisch leitenden Anschluss von elektronischen oder elektrischen Bauelementen. Das Leuchtmittel 104 ist über die Leiterplatte 106 elektrisch leitend mit einer Energiequelle gekoppelt, welche das Leuchtmittel 104 in seinem aktiven Zustand mit ausreichend Energie zum Emittieren von Licht versorgt. Das Leuchtmittel 104 kann dazu mit einem Steuergerät gekoppelt sein, welches das Leuchtmittel 104 bedarfsgerecht in einen aktiven Zustand zum Erfassen der Wählhebelposition versetzen kann. Das Steuergerät kann dabei das der Wählhebelvorrichtung oder dem Gangwechselgetriebe oder ein davon unabhängiges Steuergerät sein.

Der Lichtschacht 110 weist somit von dem Trägerelement 106 in Richtung des Wählhebels 200 abragende Wandungen auf, welche den Lichtraum 112 definieren. Der Lichtschacht 110 kann beispielsweise aus einem kunststoffhaltigen Material ausgeformt sein. Die innenseitigen Wände des Lichtschachts 110 können vorzugsweise eine reflektierende Oberflächenschicht aufweisen. Die reflektierende Oberflächenschicht kann mit dem Lichtschacht 110 zusammen ausgeformt oder in einem weiteren Prozessschritt nachträglich aufgebracht sein. Mittels des Lichtschachtes 110 wird das von dem Leuchtmittel 104 emittierte Licht in dem vordefinierten Lichtraum 112 eingefangen und in Richtung des Wählhebels 200 gelenkt.

Das Leuchtmittel 104 ist bei diesem bevorzugten Ausführungsbeispiel an einem der Gangstufe 208 für die Parksperrenstellung P zugeordnetem Ort auf dem Trägerelemente 106 angeordnet. Die Hauptausstrahlrichtung des Leuchtmittels 104 ist parallel zu einer durch das Trägerelement 106 senkrecht durchgehenden Mittenachse des Lichtraums 112 ausgerichtet. Damit wird ein Hauptlichtanteil des von dem Leuchtmittel 104 emittierten Lichts entlang der Hauptausstrahlrichtung ausgesendet, wodurch an dem Anordnungsort des Leuchtmittels 104 ein Lichtintensitätsbereich mit dem höchsten Betragswert vorherrscht. Dieses kann ferner durch die innenseitige reflektierende Oberflächenschicht des Lichtschachts 110 begünstigt werden.

Fig. 2 zeigt eine graphische Darstellung einer Lichtintensitätsverteilung beziehungsweise Lichtstärkenverteilung des Leuchtmittels 104 für die in Fig. 1 gezeigte Erfassungsvorrichtung 100. Bei dieser graphischen Darstellung ist die Lichtintensität über den Abstand in Millimeter zwischen einzelnen jeweils einer vorbestimmten Gangstufe 202, 204, 206, 208 des Kraftfahrzeuggetriebes zugeordneten Wählhebelposition gezeigt. So weist die Erfassungsvorrichtung 100 an der der Gangstufe 208 für die Parksperrenstellung P zugeordneten Wählhebelposition einen höchsten Lichtintensitätswert auf. Die Lichtintensität nimmt in dem Lichtraum 112 entlang der Drehbewegungsrichtung des Wählhebels 200 von der einen Endposition, welcher der Gangstufe 208 für die Parksperrenstellung P zugeordnet ist, zu der anderen Endposition, welcher der Gangstufe 202 für den Vorwärtsfahrbetrieb D zugeordnet ist, über die dazwischenliegenden Gangstufen 204, 206 für die Neutralstellung N und den Rückwärtsfahrbetrieb R kontinuierlich ab.

Damit ist die Lichtintensität des von dem Leuchtmittel 104 emittierten Lichts in dem Lichtraum 112 an einer ersten Zwischenposition beispielsweise für die Gangstufe 206 für den Rückwärtsfahrbetrieb R geringer als die Lichtintensität in einer ersten Endposition für die Gangstufe 208 für die Parksperrenstellung P. Entsprechend ist die Lichtintensität in einer zweiten Zwischenposition beispielsweise für die Gangstufe 204 für die Neutralstellung N geringer als die Lichtintensität in der ersten Zwischenposition. Ferner ist die Lichtintensität in einer zweiten Endposition, welcher der Gangstufe 202 für den Vorwärtsfahrbetrieb D zugeordnet ist, geringer als die Lichtintensität in der zweiten Zwischenposition. Basierend auf Lichtintensitätsverteilung kann abhängig von der Stellung des Wählhebels 200 eine Position des Wählhebels 200 eindeutig über eine Zuordnung der jeweiligen Gangstufen zu den jeweiligen Lichtintensitätswerten oder -wertebereichen erfasst werden.

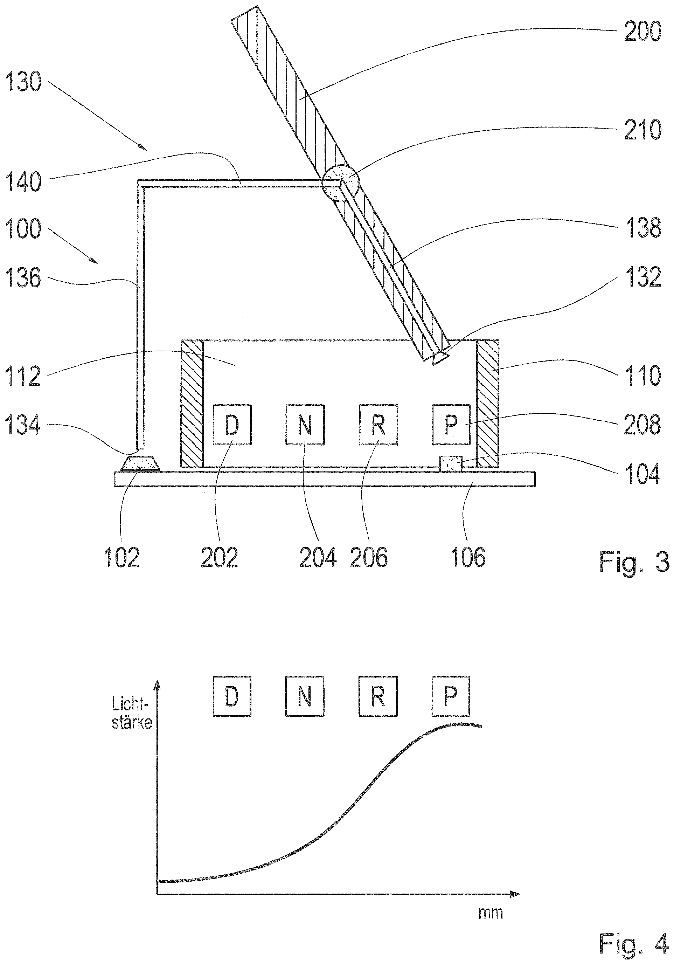

Fig. 3 zeigt eine schematische Darstellung einer Vorrichtung 100 zum optoelektronischen Erfassen unterschiedlicher Positionen eines Wählhebels 200 gemäß einem weiter bevorzugten Ausführungsbeispiel. Die Vorrichtung 100 nach diesem bevorzugten Ausführungsbeispiel unterscheidet sich von dem mit Fig. 1 gezeigten Ausführungsbeispiel durch Verwendung eines Lichtleiters 130. Im Einzelnen ist der Lichtsensor 102 außerhalb des Lichtschachtes 110 auf dem Trägerelement 106 angeordnet. Alternativ dazu kann der Lichtsensor 102 in dem Lichtschacht 110 angeordnet sein, wobei der Lichtschacht 110 ein den Lichtsensor 102 von dem Lichtraum 112 Licht abschirmendes Element aufweist, um zu vermeiden, dass der Lichtsensor 102 unmittelbar mit dem von dem Leuchtmittel 104 emittierten Licht beaufschlagt wird.

Der Lichtleiter 130 weist einen Lichteintritt 132 auf, der an dem längsseitigen Ende des Wählhebels 200, welches in den Lichtraum 112 hineinragt, angeordnet ist. Der Lichtleiter 130 umfasst ferner einen Lichtaustritt 134, welcher einer Sensorfläche des Lichtsensors 102 gegenüberliegend angeordnet ist. Der Lichteintritt 132 ist mit dem Lichtaustritt 134 über ein Lichtleitstreckenelement 136 derart verbunden, dass ein in den Lichteintritt 132 einfallender Lichtanteil des von dem Leuchtmittel 104 emittierten Lichts zu dem Lichtaustritt 134 geleitet wird. Das Lichtleitstreckenelement 136 verläuft bei diesem bevorzugten Ausführungsbeispiel innerhalb des Wählhebels 200 von dem Lichteintritt 132 über die kardanische Lagerung 210 in Richtung des Lichtaustritts 134. Der Lichtleiter 130 kann vorzugsweise flexibel ausgebildet sein. Des Weiteren kann der Lichtleiter 130 im Bereich der kardanischen Lagerung 210 eine Licht leitende Kopplungsstelle aufweisen, um einen mit dem Wählhebel 200 beweglichen Lichtleitstreckenelementabschnitt 138 mit einem aus der kardanischen Lagerung 210 herausgehenden weiteren Lichtleitstreckenelementabschnitt 140 Licht leitend zu verbinden.

Fig. 4 zeigt äquivalent zur Fig. 2 eine Lichtintensitätsverteilung der in Fig. 3 gezeigten Erfassungsvorrichtung 100. Die Verwendung eines Lichtleiters erlaubt eine Anordnung des Lichtsensors auf einem das Leuchtmittel tragenden und elektrisch anbindenden Trägerelement. Somit können ansonsten mit dem Wählhebel vorzusehende elektrische Leitungen zur elektrischen Anbindung des Lichtsensors entfallen. Dadurch lässt sich eine kostengünstigere Erfassungsvorrichtung zum optoelektronischen Erfassen bereitstellen.

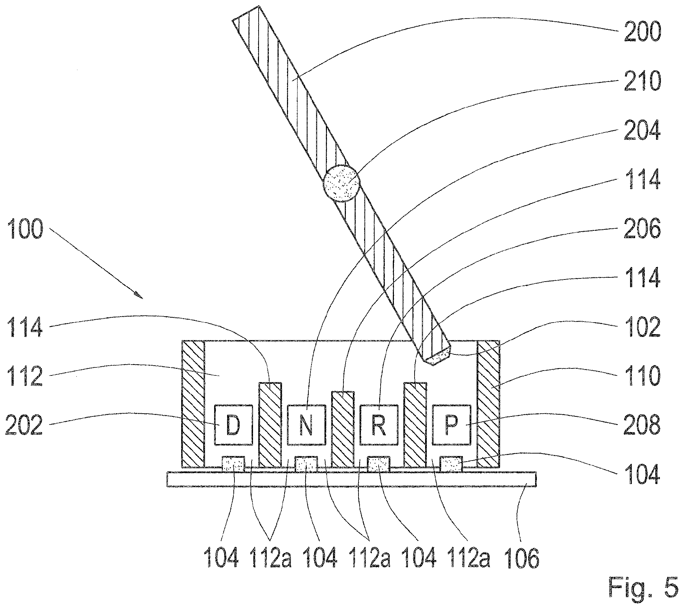

Fig. 5 zeigt eine schematische Darstellung einer Vorrichtung 100 zum optoelektronischen Erfassen unterschiedlicher Positionen eines Wählhebels 200 nach einem weiteren bevorzugten Ausführungsbeispiel. Dieses bevorzugte Ausführungsbeispiel unterscheidet sich zu dem mit Fig. 1 gezeigten bevorzugten Ausführungsbeispiel im Wesentlichen dadurch, dass für jede Wählhebelposition, welcher einer vorbestimmten Gangstufe 202, 204, 206, 208 zugeordnet ist, wenigstens ein Leuchtmittel 104 vorgesehen ist. Im Einzelnen umfasst die Erfassungsvorrichtung 100 bei diesem bevorzugten Ausführungsbeispiel einen Lichtschacht 110, in dem wenigstens vier Leuchtmittel 104 auf einem Trägerelement 106 angeordnet sind. Jeweils benachbarte Leuchtmittel 104 sind über ein Abschirmelement 114 Licht abschirmend voneinander getrennt. Dadurch werden in dem von dem Lichtschacht 110 ausgeformten Lichtraum 112 weitere Teillichträume 112a ausgebildet, in denen jeweils ein Leuchtmittel 104 angeordnet ist. Die jeweiligen Teillichträume 112a sind dabei den vorbestimmten Gangstufen 202, 204, 206, 208 beziehungsweise den entsprechenden Wählhebelpositionen zugeordnet. Die Leuchtmittel 104 sind vorgesehen, Licht mit unterschiedlicher Lichtintensität auszustrahlen. Somit kann wenigstens jeder einer Gangstufe 202, 204, 206, 208 zugeordneten Wählhebelposition ein vorbestimmter Lichtintensitätswert oder -wertebereich zum Erfassen der Wählhebelposition zugeordnet werden. Die unterschiedlichen Lichtintensitäten können beispielsweise mittels Vorwiderstände erreicht werden, welche in dem elektrischen Leitungsweg des jeweiligen Leuchtmittels 104 diesem vorgeschaltet ist. Alternativ dazu können Leuchtmittel 104 mit zueinander unterschiedlicher Abstrahlungscharakteristik hinsichtlich der Lichtintensität eingesetzt werden. Die Vorrichtung 100 nach diesem bevorzugten Ausführungsbeispiel ermöglicht eine genauere Zuordnung von Lichtintensitätswerten oder -wertebereichen den jeweiligen Wählhebelpositionen beziehungsweise den der jeweiligen Wählhebelposition zugeordneten Gangstufe.

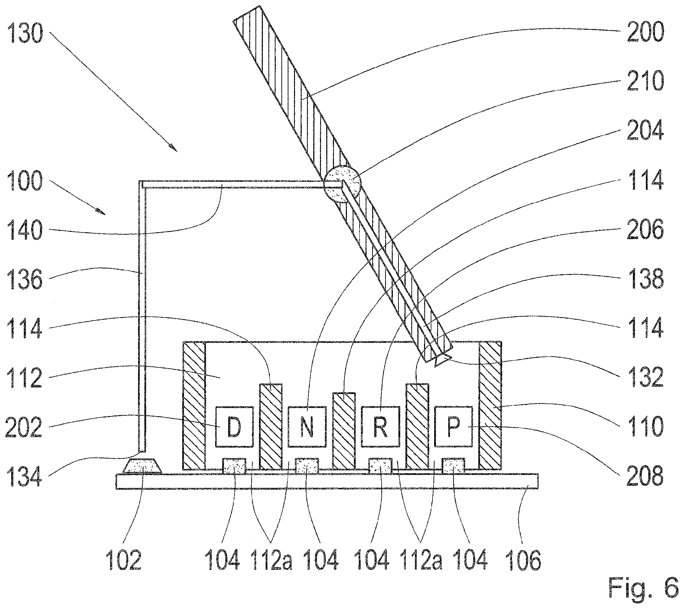

Fig. 6 zeigt eine schematische Darstellung einer Vorrichtung 100 zum optoelektronischen Erfassen unterschiedlicher Positionen eines Wählhebels 200 nach einem weiteren bevorzugten Ausführungsbeispiel. Dieses bevorzugte Ausführungsbeispiel unterscheidet sich von dem mit Fig. 5 gezeigten Ausführungsbeispiel in der Anordnung eines Lichtleiters 130 in der Lichtstrecke zwischen dem Leuchtmittel 104 und dem Lichtsensor 102. Der Lichtleiter 130 weist eine gleiche Ausgestaltung wie der Lichtleiter des mit Fig. 3 gezeigten bevorzugten Ausführungsbeispiels auf, auf welche hiermit verwiesen ist.

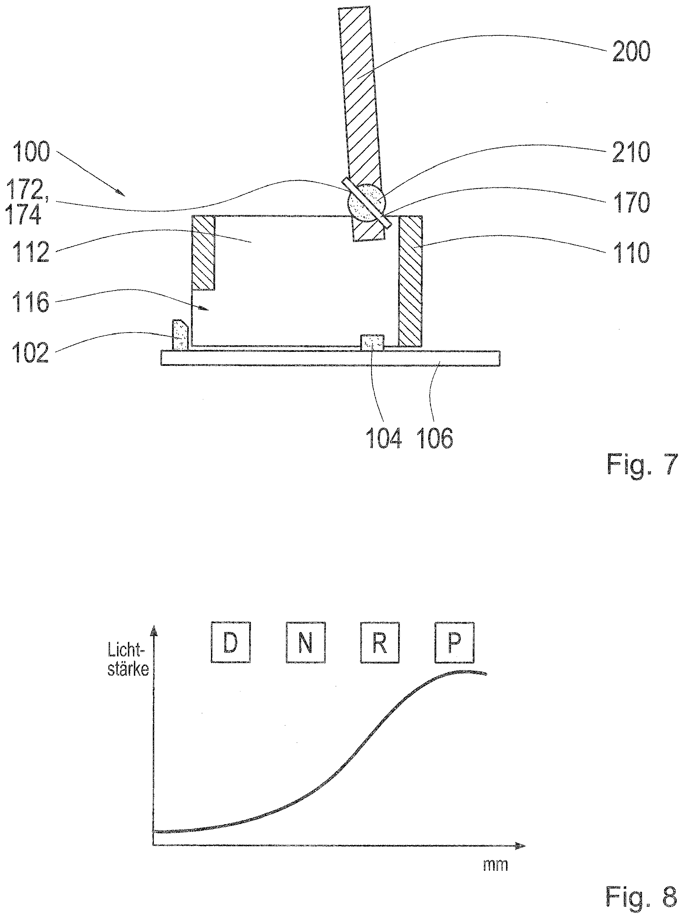

Fig. 7 zeigt eine schematische Darstellung einer Vorrichtung 100 zum optoelektronischen Erfassen unterschiedlicher Positionen eines Wählhebels 200 nach einem weiteren bevorzugten Ausführungsbeispiel. Dieses bevorzugte Ausführungsbeispiel unterscheidet sich zu dem mit Fig. 2 gezeigten bevorzugten Ausführungsbeispiel im Wesentlichen dadurch, dass anstelle eines Lichtleiters ein Lichtreflexionselement 170 im Bereich der kardanischen Lagerung 210 mit dem Wählhebel 200 mitbewegbar, im Besonderen mitdrehbar angeordnet ist. Das Lichtreflexionselement 170 ist bei diesem bevorzugten Ausführungsbeispiel durch ein Spiegelelement ausgeformt. Die dem Leuchtmittel 104 zugewandte Oberflächenseite des Spiegelelements 170 bildet den Lichteintritt 172 sowie den Lichtaustritt 174 aus. Das in den Lichteintritt 172 einfallende Licht wird unter Einhaltung des Reflexionsgesetzes über den Lichtaustritt 174 zu einem Durchgang 116 reflektiert bzw. gespiegelt, der in dem Lichtschacht 110 ausgebildet ist. Der Durchgang 116 leitet das von dem Lichtreflexionselement 170 reflektierte Licht zu einem außerhalb des Lichtraums 112 angeordneten Lichtsensors 102. Der Lichtsensor 102 ist auf dem Trägerelement 106 angeordnet.

Das Spiegelelement 170 ist bei diesem bevorzugten Ausführungsbeispiel mit einem ebenen Lichteintritt 172 und Lichtaustritt 174 gezeigt. Alternativ dazu kann der Lichteintritt 172 bzw. der Lichtaustritt 174 gewölbt oder querschnittlich gewellt sein, um eine bedarfsgerechte Lichtstreuung zu erreichen.

Das Spiegelelement 170 ist mit dem Wählhebel 200 mitdrehbar. Der Wählhebel 200 ist in einer der Parkposition P zugeordneten Endposition gezeigt. Bei Betätigung des Wählhebels 200 dreht sich das Spiegelelement 170 mit, wodurch sich eine Neigung der Lichteintrittsfläche 172 zu dem Leuchtmittel 104 und der Lichtaustrittsfläche 174 zu dem Lichtsensor 102 verändert. Dadurch wird der Lichtsensor 102 in unterschiedlichen Wählhebelpositionen mit Licht einer jeweils anderen Lichtintensität beaufschlagt.

Fig. 8 zeigt eine Lichtintensitätsverteilung der in Fig. 7 gezeigten Vorrichtung in äquivalenter Weise wie die Figuren 2 und 4. Entsprechend ist die Lichtintensität in den jeweiligen Wählhebelpositionen unterschiedlich. Somit ist durch diese kostengünstige und einfach aufgebaute Erfassungsvorrichtung gleichfalls eine zuverlässige Erfassung einer Wählhebelposition möglich.

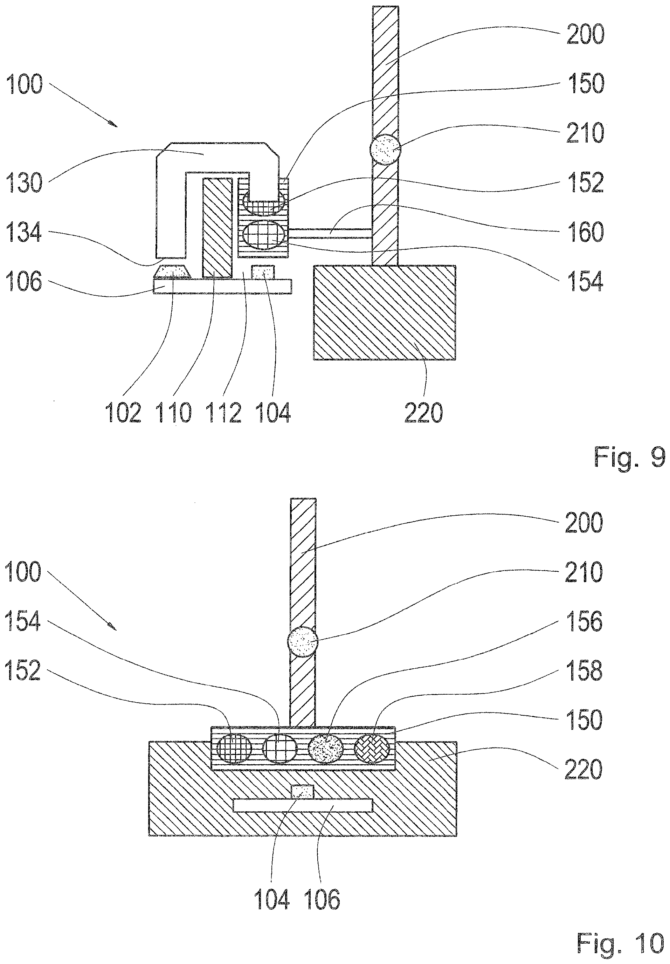

Fig. 9 und 10 zeigen jeweils eine schematische Darstellung einer Vorrichtung 100 zum optoelektronischen Erfassen unterschiedlicher Positionen eines Wählhebels 200 nach einem weiteren bevorzugten Ausführungsbeispiel. Die Vorrichtung 100 nach diesem bevorzugten Ausführungsbeispiel unterscheidet sich von den vorbeschriebenen dadurch, dass eine Wählhebelposition beziehungsweise eine einer Wählhebelposition zugeordnete Gangstufe mittels eines Lichtsensors 102 erfassbar ist, der ausgebildet ist, eine Lichtwellenlänge zu erfassen und ein der erfassten Wellenlänge entsprechendes Signal an eine Auswerteeinrichtung zu übermitteln. Dazu weist die Vorrichtung 100 einen Farbfilter 150 auf, der mit dem Wählhebel 200 verbunden ist. Der Farbfilter 150 umfasst eine der Anzahl an Gangstufen entsprechende Anzahl an unterschiedlichen Farbfilterelementen 152, 154, 156, 158. Die jeweiligen Farbfilterelemente 152, 154, 156, 158 sind vorgesehen, eine vorbestimmte Farbe eines von einem Leuchtmittel 104 emittierten Lichts durchlässig herauszufiltern. Beispielsweise kann das Farbfilterelement 152 die Farbe Grün durchlässig filtern. Das dazu benachbarte Farbfilterelement 154 kann beispielsweise dahingegen die Farbe Gelb durchlässig filtern. Das dazu benachbarte Farbfilterelement 156 kann beispielsweise dahingegen die Farbe Blau durchlässig filtern. Das dazu benachbarte Farbfilterelement 158 kann beispielsweise dahingegen die Farbe Rot durchlässig filtern. Die jeweiligen Farbfilterelemente 152, 154, 156, 158 sind entlang einer Linie angeordnet, wobei die Anordnung derart mit dem Wählhebel 200 gekoppelt ist, dass in jeder Wählhebelposition, welche einer vorbestimmten Gangstufe des Kraftfahrzeuggetriebes zugeordnet ist, ein vorbestimmtes Farbfilterelement ausgewählt aus den Farbfilterelementen 152, 154, 156, 158 einem Leuchtmittel 104 gegenüberliegend zur Anordnung kommt. Dies zeigt beispielhaft die schematische Darstellung der Fig. 9. In dieser Darstellung ist das die Farbe Gelb durchlässige Farbfilterelement 154 dem Leuchtmittel 104 gegenüberliegend angeordnet. Die dazu eingenommene Wählhebelposition des Wählhebels 200 ist der Gangstufe 204 für die Neutralstellung N zugeordnet. Damit wird das von einem Leuchtmittel 104 emittierte Licht von dem die Farbe Gelb durchlässigen Farbfilterelement 154 derart gefiltert, dass eine der Farbe Gelb entsprechende Wellenlänge von dem Farbfilterelement 154 abgestrahlt wird. Das mit dieser Wellenlänge abgestrahlte Licht wird bei diesem bevorzugten Ausführungsbeispiel mittels eines Lichtleiters 130 zu einem Lichtsensor 102 geleitet. Der Lichtsensor 102 und das Leuchtmittel 104 sind auf einem gemeinsamen Trägerelement 106, welches eine Leiterplatte ist, angeordnet und elektrisch angebunden. Der Lichtsensor 102 ist dabei außerhalb eines Lichtschachtes 110 angeordnet, wobei der Lichtschacht 110 einen Lichtraum 112 aufweist, in welchem das Leuchtmittel 104 sowie der Farbfilter 150 angeordnet sind. Der Farbfilter 150 ist über ein Befestigungselement 160 mit dem Wählhebel 200 gekoppelt, wobei das Befestigungselement 160 innerhalb einer nicht dargestellten Öffnung in einer nicht dargestellten Lichtschachtwandung frei beweglich mit dem Wählhebel 200 geführt ist.

Die Vorrichtung 100 kann bei diesem bevorzugten Ausführungsbeispiel innerhalb oder außerhalb eines nicht dargestellten Wählhebelgehäuses einer Wählhebelvorrichtung angeordnet sein. Sofern die Vorrichtung 100 außerhalb des Wählhebelgehäuses angeordnet ist, weist die Vorrichtung 100 ein die Komponenten umgebendes Gehäuse zum Schutz vor äußeren Einflüssen auf.

Der in Figuren 9 und 10 gezeigte Wählhebel 200 ist gleichfalls mittels einer kardanischen Lagerung 210 wenigstens drehbeweglich gelagert, wobei ein einem Bediener zugewandtes Ende gegenüberliegendes längsseitige Ende des Wählhebels 200 mit einer Rastiervorrichtung 220 gekoppelt ist. Mittels der Rastiervorrichtung 220 kann einem Bediener eine Auswahl einer Gangstufe haptisch angezeigt werden.

Die mit diesem bevorzugten Ausführungsbeispiel gezeigte Vorrichtung 100 erlaubt eine optoelektronische Erfassung einer Wählhebelposition auf Basis einer zu erfassenden Wellenlänge alternativ zu den vorbeschriebenen bevorzugten Ausführungsbeispielen, welche eine Wählhebelposition basierend auf den Wählhebelpositionen unterschiedlichen zugeordneten Lichtintensitäten erfassen. Ferner kann mit der Vorrichtung 100 nach diesem bevorzugten Ausführungsbeispiel eine optoelektronische Erfassungsvorrichtung mit einer reduzierten Anzahl an Leuchtmitteln bereitgestellt werden, wobei weiterhin eine zuverlässige Erfassung der jeweiligen Wählhebelpositionen beziehungsweise den unterschiedlichen Wählhebelpositionen zugeordneten Gangstufen möglich ist.

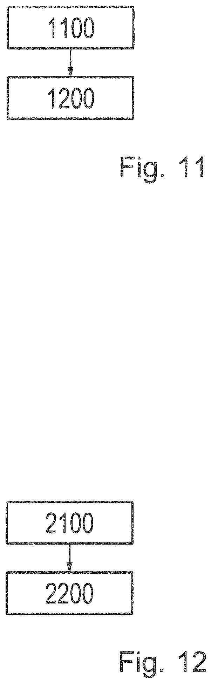

Fig. 11 zeigt ein Ablaufdiagramm eines Verfahrens zum Herstellen einer Vorrichtung zum optoelektronischen Erfassen unterschiedlicher Positionen eines Wählhebels zur Auswahl unterschiedlicher Gangstufen eines Gangwechselgetriebes, insbesondere eines Kraftfahrzeuggetriebes. Beispielsweise kann unter Verwendung des Verfahrens nach diesem bevorzugten Ausführungsbeispiel eine Vorrichtung hergestellt werden, wie sie anhand der vorangegangenen Figuren beschrieben ist.

In einem Schritt 1100 werden wenigstens ein Leuchtmittel und ein Lichtsensor bereitgestellt. Der Lichtsensor ist dabei vorgesehen, eine Lichtintensität oder eine mittels eines in eine Lichtstrecke zwischen dem wenigstens einen Leuchtmittel und dem Lichtsensor anordenbaren Lichtfilters gefilterte Wellenlänge des emittierten Lichts zu erfassen und eine Information über die erfasste Lichtintensität beziehungsweise Wellenlänge an eine Auswerteeinrichtung zu übermitteln. Dabei sind vorbestimmte Lichtintensitäten beziehungsweise vorbestimmte gefilterte Wellenlängen vorbestimmten Wählhebelpositionen, welche aus den unterschiedlichen Positionen des Wählhebels ausgewählt sind, zugeordnet.

In einem nachfolgenden Schritt werden das wenigstens eine Leuchtmittel und der Lichtsensor derart angeordnet, dass wenigstens ein Lichtanteil des von dem wenigstens einen Leuchtmittel emittierten Lichts mittels des Lichtsensors erfassbar ist.

Fig. 12 zeigt ein schematisches Ablaufdiagramm eines Verfahrens zum optoelektronischen Erfassen unterschiedlicher Positionen eines Wählhebels zur Auswahl unterschiedlicher Gangstufen eines Gangwechselgetriebes, insbesondere eines Kraftfahrzeuggetriebes, nach einem bevorzugten Ausführungsbeispiel. Beispielsweise kann unter Verwendung des Verfahrens nach diesem bevorzugten Ausführungsbeispiel eine optoelektronische Erfassung unter Verwendung einer Vorrichtung durchgeführt werden, wie sie anhand der vorangegangenen Figuren beschrieben ist.

In einem Schritt 2100 wird der Wählhebel in eine von einer Ausgangsposition unterschiedliche Position bewegt. Bei der Ausgangsposition kann es sich um eine der vorbeschriebenen Gangstufen entsprechend zugeordnete Wählhebelposition handeln, während die dazu unterschiedliche Wählhebelposition eine Wählhebelposition ist, welcher eine zu der Ausgangsposition unterschiedliche Gangstufe zugeordnet ist.

In einem weiteren Schritt 2200 wird ein Lichtanteil eines von einem Leuchtmittel emittierten Lichts mittels eines Lichtsensors erfasst. Der Lichtsensor ist dabei vorgesehen, eine Lichtintensität oder eine mittels eines in eine Lichtstrecke zwischen dem wenigstens einen Leuchtmittel und dem Lichtsensor anordenbaren Lichtfilters gefilterte Wellenlänge des emittierten Lichts zu erfassen und eine Information über die erfasste Lichtintensität beziehungsweise Wellenlänge an eine Auswerteeinrichtung zu übermitteln, wobei vorbestimmte Lichtintensitäten beziehungsweise vorbestimmte gefilterte Wellenlängen vorbestimmten Wählhebelpositionen, welche aus den unterschiedlichen Positionen des Wählhebels ausgewählt sind, zugeordnet sind.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können Verfahrensschritte wiederholt sowie in einer anderen als in der beschriebenen Reihenfolge ausgeführt werden, sofern sinnhaft möglich.

### Bezugszeichen

- 100: Vorrichtung
- 102: Lichtsensor
- 104: Leuchtmittel
- 106: Trägerelement
- 110: Lichtschacht
- 112: Lichtraum
- 112a: Teillichtraum
- 114: Lichtabschirmelement
- 116: Durchgang
- 130: Lichtleiter
- 132, 172: Lichteintritt
- 134, 174: Lichtaustritt
- 136: Lichtleitstreckenelement
- 138: erster Lichtleitstreckenelementabschnitt
- 140: zweiter Lichtleitstreckenelementabschnitt
- 150: Farbfilter
- 152, 154, 154, 158: Farbfilterelemente
- 160: Befestigungselement
- 170: Lichtreflexionselement
- 200: Wählhebel
- 202, 204, 206, 208: Gangstufe
- 210: kardanische Lagerung
- 220: Rastvorrichtung
- 1100: Schritt des Bereitstellens
- 1200: Schritt des Anordnens
- 2100: Schritt des Bewegens
- 2200: Schritt des Erfassens

## Patentansprüche

1. Vorrichtung (100) zum optoelektronischen Erfassen unterschiedlicher Positionen eines Wählhebels (200) zur Auswahl unterschiedlicher Gangstufen (202; 204; 206; 208) eines Gangwechselgetriebes, insbesondere eines Kraftfahrzeuggetriebes, wobei die Erfassungsvorrichtung (100) mit dem Wählhebel (200) koppelbar ist und wenigstens ein Leuchtmittel (104) zum Emittieren von Licht und einen Lichtsensor (102) zum Erfassen des emittierten Lichts umfasst, wobei der Lichtsensor (102) vorgesehen ist, eine mittels eines in eine Lichtstrecke zwischen dem wenigstens einen Leuchtmittel (104) und dem Lichtsensor (102) anordbaren Lichtfilters (150) gefilterte Wellenlänge des emittierten Lichts zu erfassen und eine Information über die erfasste Wellenlänge an eine Auswerteeinrichtung zu übermitteln, wobei vorbestimmte gefilterte Wellenlängen vorbestimmten Wählhebelpositionen, welche aus den unterschiedlichen Positionen des Wählhebels (200) ausgewählt sind, zugeordnet sind.

2. Erfassungsvorrichtung (100) nach Anspruch 1, **dadurch gekennzeichnet**, dassdie Erfassungsvorrichtung (100) einen Lichtschacht (110) umfasst, welcher einen Lichtraum (112) begrenzt, in welchem das wenigstens eine Leuchtmittel (104) angeordnet ist, und dass ein Lichteintritt (132; 172) angrenzend zu oder in dem Lichtraum (112) zu dem wenigstens einem Leuchtmittel (104) relativ beweglich an dem Wählhebel (200) befestigbar ist, wobei der Lichtsensor (102) mit dem Lichteintritt (132; 172) derart gekoppelt ist, dass der Lichtsensor (102) wenigstens einen Anteil eines in den Lichteintritt (132; 172) einfallenden Lichtanteils des emittierten Lichts sensiert.

3. Erfassungsvorrichtung (100) nach Anspruch 1 oder 2, **dadurch gekennzeichnet, dass** der Lichtsensor (102) an dem Wählhebel (200) befestigbar ist, wobei der Lichteintritt (132) von dem Lichtsensor (102) umfasst ist.

4. Erfassungsvorrichtung (100) nach Anspruch 1 oder 2, **dadurch gekennzeichnet, dass** ein Lichtleiter (130) an dem Wählhebel (200) befestigbar ist, welches einen Lichtaustritt (134) umfasst, der gegenüber einer Sensorfläche des Lichtsensors (102) angeordnet ist, wobei der Lichtaustritt (134) mit dem Lichteintritt (132) über ein Lichtleitstreckenelement (136) miteinander verbunden ist, mittels welchem der in den Lichteintritt (132) einfallende Lichtanteil des emittierten Lichts zu dem Lichtaustritt (134) geleitet wird.

5. Erfassungsvorrichtung (100) nach einem der Ansprüche 2 bis 4, **dadurch gekennzeichnet, dass** in dem Lichtschacht (110) für jede von dem Wählhebel (200) einnehmbare Position zur Auswahl einer Gangstufe (202; 204; 206; 208) ein Leuchtmittel (104) angeordnet ist, wobei jeweils benachbarte Leuchtmittel (104) mittels eines dazwischen angeordneten Lichtabschirmelements (114) zueinander abgeschirmt und ausgebildet sind, Licht mit einer zueinander unterschiedlichen Lichtintensität zu emittieren.

6. Erfassungsvorrichtung (100) nach Anspruch 2, **dadurch gekennzeichnet, dass** der Lichtschacht (110) einen zu dem Lichtsensor (102) führenden Durchgang (116) aufweist, und dass ein Lichtreflexionselement (170) an dem Wählhebel (200) befestigbar ist, welches den Lichteintritt (172) und einen Lichtaustritt (174) ausbildet, wobei ein in den Lichteintritt (172) einfallender Lichtanteil des emittierten Lichts über den Lichtaustritt (174) in Richtung des Durchganges (116) reflektiert wird.

7. Erfassungsvorrichtung (100) nach Anspruch 1 oder 2, **dadurch gekennzeichnet, dass** ein Lichtfilter (150) an dem Wählhebel (200) in einer Lichtstrecke zwischen dem Leuchtmittel (104) und dem Lichtsensor (102) befestigbar ist, wobei der Lichtfilter (150) eine Anzahl an zu erfassenden unterschiedlichen Wählhebelpositionen gleiche Anzahl an unterschiedlichen Farbfilterelementen (152, 154, 156, 158) zum vorbestimmten Filtern des in den Lichteintritt einfallenden Lichtanteils des emittierten Lichts aufweist, wobei jedes Farbfilterelement (152, 154, 156, 158) mit einer dem Leuchtmittel (104) zugewandten Oberflächenseite den Lichteintritt ausformt.

8. Erfassungsvorrichtung (100) nach einem der Ansprüche 4, 5 in Kombination mit 4, 6 oder 7, **dadurch gekennzeichnet, dass** der Lichtsensor (102) und das wenigstens eine Leuchtmittel (104) auf einem gemeinsamen Trägerelement (106) angeordnet sind.

9. Wählhebelvorrichtung für ein Gangwechselgetriebe, insbesondere ein Kraftfahrzeuggetriebe, umfassend einen zwischen unterschiedlichen Positionen beweglichen Wählhebel (200) zur Auswahl unterschiedlicher Gangstufen (202, 204, 206, 208) des Gangwechselgetriebes, **dadurch gekennzeichnet, dass** der Wählhebel (200) eine Kopplungsstelle zur Kopplung mit einer Vorrichtung (100) nach einem der vorhergehenden Ansprüche aufweist.

10. Verfahren zum optoelektronischen Erfassen unterschiedlicher Positionen eines Wählhebels (200) zur Auswahl unterschiedlicher Gangstufen (202, 204, 206, 208) eines Gangwechselgetriebes, umfassend einen Schritt (2100) des Bewegens des Wählhebels (200) in eine von einer Ausgangsposition unterschiedliche Position, und einen Schritt (2200) des Erfassens eines Lichtanteils eines von wenigstens einem Leuchtmittel (104) emittierten Lichts mittels eines Lichtsensors (102), wobei der Lichtsensor (102) vorgesehen ist, eine mittels eines in eine Lichtstrecke zwischen dem wenigstens einen Leuchtmittel (104) und dem Lichtsensor (102) anordbaren Lichtfilters (150) gefilterte Wellenlänge des emittierten Lichts zu erfassen und eine Information über die erfasste Wellenlänge an eine Auswerteeinrichtung zu übermitteln, wobei vorbestimmte gefilterte Wellenlängen vorbestimmten Wählhebelpositionen, welche aus den unterschiedlichen Positionen des Wählhebels (200) ausgewählt sind, zugeordnet sind.

## Claims

1. Apparatus (100) for optoelectronically capturing different positions of a selector lever (200) for selecting different gear steps (202; 204; 206; 208) for a gear speed change transmission, in particular a motor vehicle transmission, wherein the capturing apparatus (100) is able to be coupled with the selector lever (200) and comprises at least one light-emitting means (104) for emitting light and a light sensor (102) for capturing the emitted light, wherein the light sensor (102) is provided to capture a wavelength of the emitted light that has been filtered using a light filter (150) which is arrangeable in a light path between the at least one light-emitting means (104) and the light sensor (102) and to transmit information relating to the captured wavelength to an evaluation device, wherein predetermined filtered wavelengths are assigned to predetermined selector lever positions which are selected from the different positions of the selector lever (200).

2. Capturing apparatus (100) according to Claim 1, **characterized in that** the capturing apparatus (100) comprises a light shaft (110), which delimits a light space (112) in which the at least one light-emitting means (104) is arranged, and **in that** a light entrance (132; 172) is attachable to the selector lever (200) adjacent to, or in, the light space (112) in a manner such that it is movable relative to the at least one light-emitting means (104), wherein the light sensor (102) is coupled to the light entrance (132; 172) such that the light sensor (102) senses at least a portion of a light portion of the emitted light that is incident in the light entrance (132; 172).

3. Capturing apparatus (100) according to Claim 1 or 2, **characterized in that** the light sensor (102) is attachable to the selector lever (200), wherein the light entrance (132) is comprised by the light sensor (102) .

4. Capturing apparatus (100) according to Claim 1 or 2, **characterized in that** a light guide (130) is attachable to the selector lever (200), which comprises a light exit (134) which is arranged opposite a sensor surface of the light sensor (102), wherein the light exit (134) is connected to the light entrance (132) via a light guide section element (136), by way of which the light portion of the emitted light that is incident in the light entrance (132) is guided to the light exit (134) .

5. Capturing apparatus (100) according to one of Claims 2 to 4, **characterized in that** a light-emitting means (104) is arranged in the light shaft (110) for each position that is adoptable by the selector lever (200) for selecting a gear step (202; 204; 206; 208), wherein respectively adjacent light-emitting means (104) are shielded from one another using a light shielding element (114) that is arranged therebetween and are configured to emit light with a light intensity that differs from one light-emitting means (104) to another.

6. Capturing apparatus (100) according to Claim 2, **characterized in that** the light shaft (110) has a through-passage (116) leading to the light sensor (102), and **in that** attachable to the selector lever (200) is a light reflection element (170) which forms the light entrance (172) and a light exit (174), wherein a light portion of the emitted light that is incident in the light entrance (172) is reflected, via the light exit (174), in the direction of the through-passage (116).

7. Capturing apparatus (100) according to Claim 1 or 2, **characterized in that** a light filter (150) is attachable to the selector lever (200) in a light path between the light-emitting means (104) and the light sensor (102), wherein the light filter (150) has a number of different colour filter elements (152, 154, 156, 158) for the predetermined filtering of the light portion of the emitted light that is incident in the light entrance, said number being equal to the number of different selector lever positions to be captured, wherein each colour filter element (152, 154, 156, 158) forms the light entrance with a surface side facing the light-emitting means (104).

8. Capturing apparatus (100) according to one of Claims 4, 5 in combination with 4, 6 or 7, **characterized in that** the light sensor (102) and the at least one light-emitting means (104) are arranged on a common carrier element (106).

9. Selector lever apparatus for a gear speed change transmission, in particular a motor vehicle transmission, comprising a selector lever (200), which is movable between different positions, for selecting different gear steps (202, 204, 206, 208) of the gear speed change transmission, **characterized in that** the selector lever (200) has a coupling location for coupling to an apparatus (100) according to one of the preceding claims.

10. Method for optoelectronically capturing different positions of a selector lever (200) for selecting different gear steps (202, 204, 206, 208) of a gear speed change transmission, comprising a step (2100) of moving the selector lever (200) into a position that differs from a start position and a step (2200) of capturing a light portion of a light that is emitted by at least one light-emitting means (104) using a light sensor (102), wherein the light sensor (102) is provided to capture a wavelength of the emitted light that has been filtered using a light filter (150) which is arrangeable in a light path between the at least one light-emitting means (104) and the light sensor (102) and to transmit information relating to the captured wavelength to an evaluation device, wherein predetermined filtered wavelengths are assigned to predetermined selector lever positions which are selected from the different positions of the selector lever (200).

## Revendications

1. Arrangement (100) de détection optoélectronique de différentes positions d'un levier de sélection (200) destiné à sélectionner différents rapports de transmission (202 ; 204 ; 206 ; 208) d'une boîte de transmission à changement de rapport, notamment d'une boîte de vitesses de véhicule automobile, l'arrangement de détection (100) pouvant être couplé au levier de sélection (200) et comportant au moins une source lumineuse (104) destinée à émettre de la lumière et un capteur de lumière (102) destiné à détecter la lumière émise,
le capteur de lumière (102) étant conçu pour détecter une longueur d'onde de la lumière émise, filtrée au moyen d'un filtre à lumière (150) qui peut être disposé dans un trajet de lumière entre l'au moins une source lumineuse (104) et le capteur de lumière (102) et communiquer une information à propos de la longueur d'onde détectée à un dispositif d'interprétation, des longueurs d'onde filtrées prédéterminées étant associées à des positions de levier de sélection prédéterminées qui sont choisies parmi les différentes positions du levier de sélection (200).

2. Arrangement de détection (100) selon la revendication 1, **caractérisé en ce que** l'arrangement de détection (100) comporte un puits de lumière (110) qui délimite un espace de lumière (112) dans lequel est disposée l'au moins une source lumineuse (104), et **en ce qu'**une entrée de lumière (132 ; 172) adjacente à l'espace de lumière (112) ou dans celui-ci peut être fixée au levier de sélection (200) de manière mobile par rapport à l'au moins une source lumineuse (104), le capteur de lumière (102) étant couplé à l'entrée de lumière (132 ; 172) de telle sorte que le capteur de lumière (102) détecte au moins une part d'une portion de lumière de la lumière émise qui est incidente dans l'entrée de lumière (132 ; 172).

3. Arrangement de détection (100) selon la revendication 1 ou 2, **caractérisé en ce que** le capteur de lumière (102) peut être fixé au levier de sélection (200), l'entrée de lumière (132) étant comprise par le capteur de lumière (102).

4. Arrangement de détection (100) selon la revendication 1 ou 2, **caractérisé en ce qu'**une fibre optique (130) peut être fixée au levier de sélection (200), laquelle comporte une sortie de lumière (134) qui est disposée à l'opposé d'une surface de capteur du capteur de lumière (102), la sortie de lumière (134) étant reliée ensemble à l'entrée de lumière (132) par le biais d'un élément de trajet de guidage de lumière (136) au moyen duquel la part de lumière de la lumière émise qui est incidente dans l'entrée de lumière (132) est guidée vers la sortie de lumière (134).

5. Arrangement de détection (100) selon l'une des revendications 2 à 4, **caractérisé en ce qu'**une source lumineuse (104) est disposée dans le puits de lumière (110) pour chaque position pouvant être adoptée par le levier de sélection (200) en vue de sélectionner un rapport de transmission (202 ; 204 ; 206 ; 208), les sources de lumière (104) respectivement voisines étant protégées les unes des autres au moyen d'un élément pare-lumière (114) disposé entre elles et étant configurées pour émettre de la lumière avec des intensités lumineuses différentes les unes des autres.

6. Arrangement de détection (100) selon la revendication 2, **caractérisé en ce que** le puits de lumière (110) possède un passage (116) qui mène au capteur de lumière (102), et **en ce qu'**un élément de réflexion de lumière (170) peut être fixé au levier de sélection (200), lequel forme l'entrée de lumière (172) et une sortie de lumière (174), une part de lumière de la lumière émise qui est incidente dans l'entrée de lumière (172) étant réfléchie par le biais de la sortie de lumière (174) en direction du passage (116).

7. Arrangement de détection (100) selon la revendication 1 ou 2, **caractérisé en ce qu'**un filtre à lumière (150) peut être fixé sur le levier de sélection (200) dans un trajet de lumière entre la source lumineuse (104) et le capteur de lumière (102), le filtre à lumière (150) possédant un nombre d'éléments de filtre de couleur (152, 154, 156, 158) différents, égal au nombre de positions différentes à détecter du levier de sélection, destinés à filtrer de manière prédéterminée la part de lumière de la lumière émise qui est incidente dans l'entrée de lumière, chaque élément de filtre de couleur (152, 154, 156, 158) formant l'entrée de lumière avec un côté de surface qui fait face à la lumineuse (104).

8. Arrangement de détection (100) selon l'une des revendications 4, 5 en combinaison avec la revendication 4, 6 ou 7, **caractérisé en ce que** le capteur de lumière (102) et l'au moins une source lumineuse (104) sont disposés sur un élément porteur (106) commun.

9. Arrangement de levier de sélection pour une boîte de transmission à changement de rapport, notamment une boîte de vitesses de véhicule automobile, comprenant un levier de sélection (200) mobile entre différentes positions destiné à sélectionner différents rapports de transmission (202, 204, 206, 208) de la boîte de transmission à changement de rapport, **caractérisé en ce que** le levier de sélection (200) possède un point d'accouplement servant à l'accouplement avec un arrangement (100) selon l'une des revendications précédentes.

10. Procédé de détection optoélectronique de différentes positions d'un levier de sélection (200) destiné à sélectionner différents rapports de transmission (202, 204, 206, 208) d'une boîte de transmission à changement de rapport, comprenant une étape (2100) de déplacement du levier de sélection (200) dans une position différente d'une position initiale, et une étape (2200) de détection d'une part de lumière d'une lumière émise par au moins une source lumineuse (104) au moyen d'un capteur de lumière (102), le capteur de lumière (102) étant conçu pour détecter une longueur d'onde de la lumière émise, filtrée au moyen d'un filtre à lumière (150) qui peut être disposé dans un trajet de lumière entre l'au moins une source lumineuse (104) et le capteur de lumière (102) et communiquer une information à propos de la longueur d'onde détectée à un dispositif d'interprétation, des longueurs d'onde filtrées prédéterminées étant associées à des positions de levier de sélection prédéterminées qui sont choisies parmi les différentes positions du levier de sélection (200).
